# EUROPEAN PATENT APPLICATION

(11) **EP 4 765 571 A1**
(43) Date of publication of application: **24.06.2026**
(21) Application number: 25222730.1
(22) Date of filing: 11.12.2025
(51) Int. Cl.: H02J 7/40, H02J 7/80

(54) **BATTERY PACK ALARM SYSTEM**

(30) Priority: 20.12.2024 US 202418989942
(71) Applicant: Schneider Electric IT Corporation, Foxboro, MA 02035 (US)
(72) Inventor: XU, Cheng, SHANGHAI (CN); XIA, Wei, SHANGHAI (CN); KONG, Qinggang, SHANGHAI (CN); QIU, Yufei, SHANGHAI (CN)
(74) Representative: Plasseraud IP

(57) **Abstract**

A system for managing addressing is provided, the system including a first subordinate device coupled to a communication bus, a first address line, and a second address line, the first subordinate device including a first switch coupled between the first address line and the second address line and configured to selectively connect the first address line to the second address line, a first alarm input configured to receive an alarm signal, and a second switch configured to establish an alarm voltage on the first address line.

## Description

### BACKGROUND

### 1. Field of the Disclosure

At least one example in accordance with the present disclosure relates generally to alarm systems for linked battery packs.

### 2. Discussion of Related Art

Battery packs can experience faults. When a battery pack experiences a fault, an alarm can be provided so that corrective measures can be taken.

### SUMMARY

According to at least one aspect of the present disclosure a system is presented, comprising: a first subordinate device coupled to a communication bus, a first address line, and a second address line, the first subordinate device including a first switch coupled between the first address line and the second address line and configured to selectively connect the first address line to the second address line, a first alarm input configured to receive an alarm signal, and a second switch configured to establish an alarm voltage on the first address line.

In some examples, the second switch is coupled between the first address line and a voltage node and configured to be in a closed state responsive to the alarm signal being present at the first alarm input, and to be in an open state responsive to the alarm signal being absent from the first alarm input. In some examples, the system further comprises a second subordinate device coupled to the communication bus and to the second address line, the second subordinate device including a third switch coupled between the second address line and the voltage node, and a second alarm input configured to receive a second alarm signal, wherein the third switch is configured to be in a closed state responsive to the second alarm signal being present at the second alarm input, and to be in an open state responsive to the second alarm signal absent from the second alarm input. In some examples, the system further comprises a third subordinate device coupled to the communication bus and a third address line, the second subordinate device being coupled to the third address line and including a fourth switch coupled between the second address line and the third address line and configured to selectively connect the second address line and the third address line. In some examples, the voltage node is configured to pull down a voltage on the first address line to a reference voltage level responsive to the first switch and the third switch both being in respective closed states. In some examples, the first subordinate device includes a first impedance coupled between the first address line and a first enable switch, and the second subordinate device has a second impedance coupled between the second address line and a second enable switch. In some examples, the system further comprises one or more additional subordinate devices, a leading subordinate device of the one or more additional subordinate devices being coupled to the second address line, and each other subordinate device of the one or more additional subordinate devices being coupled to at least one preceding subordinate device of the one or more additional subordinate devices via a respective preceding address line, and being further coupled to at least one following subordinate device of the one or more additional subordinate devices via a respective following address line; and a supervisory device configured to detect whether a voltage of the first address line falls within a predetermined range of voltages, and responsive to determining that the voltage falls within the predetermined range of voltages, to determine, via the communication bus, when subordinate devices of the first subordinate device and the one or more additional subordinate devices have respective alarm signals present on respective alarm inputs. In some examples, the first subordinate device further includes a first enable switch having an open and closed state, the first enable switch being coupled to an ID input, wherein the first enable switch is configured to be in a closed state responsive to an input signal being present on the ID input, and to be in an open state responsive to the input signal being absent from the ID input. In some examples, responsive to the first enable switch being in the closed state, the first subordinate device is configured to receive a network address from the communication bus and to set the network address as the network address of the first subordinate device. In some examples, the voltage node has a reference voltage level and is configured to pull a voltage on at least the first address line down to the reference voltage level responsive to the second switch being in a closed state.

According to at least one aspect of the present disclosure, a method of detecting a fault in a battery pack is presented, the method comprising: providing a first voltage on a first address line, the first address line coupled to a first subordinate device; detecting a fault; responsive to detecting the fault, providing a second voltage on the first address line; detecting the second voltage on the second address line; responsive to detecting the second voltage on the second address line, providing instructions via a communication bus to a subordinate device experiencing the fault.

In some examples, the method further comprises coupling the first address line in series with one or more additional address lines, the first address line and each additional address line of the one or more address lines being coupled to a respective fault switch of a respective subordinate device, each respective fault switch being configured to receive a respective fault signal, wherein responsive to receiving the respective fault signal the respective fault switch is set into a closed state. In some examples, in the closed state, the respective fault switch couples a respective address line of the first address line and the one or more additional address lines to a voltage node, the voltage node having a predetermined voltage. In some examples, connecting the respective address line to the voltage node pulls the voltage of the first address line to the predetermined voltage of the voltage node. In some examples, responsive to detecting the predetermined voltage on the first address line, determining that a fault has occurred in at least one subordinate device. In some examples, the method further comprises responsive to detecting the predetermined voltage on the first address line, monitoring signals on the communication bus to determine an identity of the at least one subordinate device experiencing the fault.

According to at least one aspect of the present disclosure, a non-transitory computer-readable medium is presented, containing thereon instructions for detecting faults in one or more subordinate devices, the instructions, when executed by at least one processor, causing: a supervisory device to provide a first voltage to a first address line, the first address line being coupled between the supervisory device and a subordinate device of the one or more subordinate devices; the supervisory device to detect changes in the first voltage; the supervisory device to determine whether the first voltage falls within a predetermined voltage range, the predetermined voltage range corresponding to a range of voltages that indicate a fault has occurred in at least one of the one or more subordinate devices; and the supervisory device to monitor communications on a communication bus to determine which subordinate device of the one or more subordinate devices is experiencing the fault.

In some examples, the instructions, when executed by the at least one processor, further cause: responsive to providing the first voltage on the first address line, the supervisory device to provide a network address to the subordinate device. In some examples, the instructions, when executed by the at least one processor, further cause: responsive to providing the first address, a switching device to be in a closed state to couple the first address line to a second address line. In some examples, the instructions, when executed by the at least one processor, further cause: the subordinate device to detect a fault condition; and responsive to detecting the fault condition, the subordinate device to control a switching device to be in a closed state, the switching device being coupled to ground and configured, when closed, to pull the first voltage of the first address line to a target voltage that falls within the predetermined voltage range.

### BRIEF DESCRIPTION OF THE DRAWINGS

Various aspects of at least one embodiment are discussed below with reference to the accompanying figures, which are not intended to be drawn to scale. The figures are included to provide an illustration and a further understanding of the various aspects and embodiments, and are incorporated in and constitute a part of this specification, but are not intended as a definition of the limits of any particular embodiment. The drawings, together with the remainder of the specification, serve to explain principles and operations of the described and claimed aspects and embodiments. In the figures, each identical or nearly identical component that is illustrated in various figures is represented by a like numeral. For purposes of clarity, not every component may be labeled in every figure. In the figures:
FIG. 1 illustrates a networked system according to an example;
FIG. 2 illustrates a networked system according to an example; and
FIG. 3 illustrates a process for interrupting an addressing process according to an example.

### DETAILED DESCRIPTION

In some electronic and/or power systems, battery packs may be installed on a network so that the battery packs (or the devices to which they are coupled, such as uninterruptible power supplies (UPSs)) may communicate with a control device. Communicating with the control device may be useful because it permits the battery packs (or related devices) to receive instructions from the control device and to communicate status to the control device. For example, a battery pack can inform the control device that there is a problem, such as a fault, and the control device can then take appropriate corrective action, such as disabling or disconnecting the battery pack, raising an alarm so that an engineer can investigate, and so forth. However, when the control device managing the battery packs is busy-for example, performing a different task such as assigning network addresses, or otherwise unable to promptly receive notifications from the battery packs-an indication of an alarm, such as a fault condition, or any indication of any other type positive or negative condition generated by the battery packs may not be received in a timely manner, resulting in possible damage to the battery packs or the system using them.

To communicate on a network, devices-including battery packs-generally require a network address. The network address is a unique address that corresponds to the device. The network address permits the control device to know which device it is communicating with (e.g., where communications originate and/or where communications are directed). This, in turn, permits the control device to control specific devices on the network without worry that instructions intended for one device may be executed by a different device. It also allows devices on the network to determine whether an instruction originated from the control device or from another device, and thereby avoid executing instructions originating from unauthorized sources. However, when a network is starting up, devices on the network may not have yet been assigned network addresses and/or unique network addresses, and the control device may not know the network addresses of the devices on the network. Therefore, network addresses often need to be assigned to devices on the network for the network to function properly.

One example of how to assign network address is disclosed in U.S. Patent Application 18/815,065, titled "Dynamic CAN Addressing," which concerns methods of Controller Area Network (CAN) addressing. U.S. Patent Application 18/815,065, "Dynamic CAN Addressing," is hereby incorporated by reference in its entirety for all purposes.

However, issues can arise when assigning network addresses. The process of assigning network addresses takes time, and may also require the use of communication busses, inputs, outputs, and other data or voltage lines in the system, and any other connection between devices in the network (collectively "network connections"). Because these network connections may be monopolized by the control device during the network addressing process, if a device wants or needs to use the network connections, the device may be unable to do so, which may lead to undesirable results.

Accordingly, aspects of this disclosure relate to systems and methods for permitting a device to inform the control device of a condition or desire to use network connections or other network resources during the addressing process. That is, examples disclosed herein permit any device of the various devices on the network to interrupt the use of network resources by other devices, including the control device, in order to provide status updates or important information to the control device. In one example, the control device is coupled to a network connection that can be pulled up or down to a specific voltage and/or voltage range. When the network connection is pulled to the specific voltage and/or voltage range, the control device may recognize that a device on the network wishes to use network connections or resources, and may pause or terminate the network addressing process to permit the device to do so. In some examples, a subordinate device may interrupt the addressing process (e.g., the process of assigning network addresses to devices on the network) to inform the control device of a change in status or other situation, such as the occurrence of a fault that might result in undesirable outcomes if allowed to persist. Thus, examples disclosed herein permit networked battery pack systems to interrupt, as soon as desired and without waiting, network resource usage by the control device and/or other devices one the network to temporarily take over the network resources to send an indication (e.g., alarm) of a fault condition to the control device. Accordingly, aspects of the present disclosure permit the control device to timely receive notification of a fault, thereby giving the control device time to take remedial action, such as deactivating or disconnecting a faulty device and/or devices coupled to the faulty device.

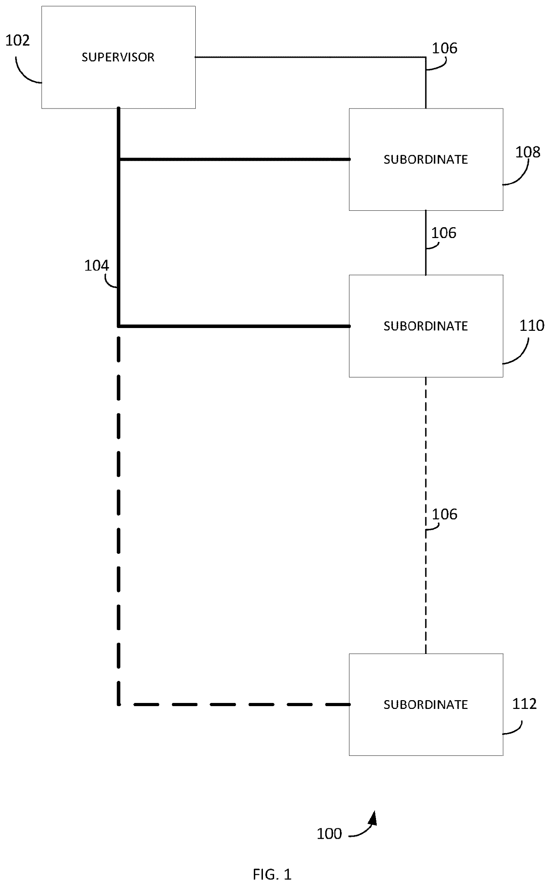

FIG. 1 illustrates a networked system 100 ("system 100") according to an example. The system 100 is an example of a system that this disclosure may apply to. The system 100 includes a supervisory device 102 ("supervisor 102"), a communication bus 104, an address line 106, a first subordinate device 108, a second subordinate device 110, and a last subordinate device 112. The system may also include other subordinate devices (e.g., subordinate devices coupled between the second subordinate device 110 and the last subordinate device 112). The communication bus 104 and address line 106 are both network connections in this context.

The supervisor 102 is coupled to the communication bus 104 and the address line 106. The address line 106 has multiple sections or portions. The supervisor 102 is coupled to the first address line, which is the portion of the address line 106 coupled between the supervisor 102 and the first subordinate device 108.

The first subordinate device 108 is coupled to the communication bus 104 and to the address line 106. In particular, the first subordinate device 108 is coupled to the first address line and to the second address line, the second address line being the portion of the address line 106 coupled between the first subordinate device 108 and the second subordinate device 110.

The second subordinate device 110 is coupled to the second address line, the communication bus 104, and a third address line, the third address line being the portion of the address line 106 coupled between the second subordinate device 110 and the next subordinate device in the chain. It will be appreciated that any number of subordinate devices may be present, and that the subordinate devices may, with respect to the address line 106, be arranged in a linear chain, where each subordinate device (other than the first and last) is coupled to a preceding subordinate device by a preceding address line, where the preceding address line is the portion of the address line 106 coupled between the subordinate device and its preceding subordinate device, and is coupled to a next subordinate device by a following address line, the following address line being the portion of the address line 106 coupled between the subordinate device and the next subordinate device.

The last subordinate device 112 is coupled, via a preceding portion of the address line 106, to a penultimate subordinate device. The last subordinate device is also coupled to the communication bus 104. Note that, in general, each subordinate device is coupled to the communication bus 104.

The supervisor 102 manages the network, and is the control device of the system 100. The supervisor 102 can be any type of computer or specialized circuit, such as a microcontroller, processor, distributing processing system, an ASIC or FPGA, and so forth. The supervisor 102 can assign network addresses to the subordinate devices (e.g., the first subordinate device 108, second subordinate device 110, last subordinate device 112, and so forth).

The subordinate devices may be any type of device that can be assigned a network address, including but not limited to battery packs, UPSs, and so forth. The subordinate devices may be able to selectively connect and disconnect the portions of the address line 106 to which they are connected with each other. For example, the first subordinate device 108 may selectively couple the first address line to the second address line. Likewise, the second subordinate device 110 may selectively couple the second address line to the third address line. Generally, a subordinate device may selectively couple its preceding address line to its following address line.

In some examples, the supervisor 102 assigns network addresses by asserting a signal (for example, a voltage) on the address line 106. Because the subordinate devices may default to not connecting preceding and following address lines, the signal may only be seen (that is, received) by the first subordinate device 108 initially. This signal may inform the first subordinate device 108 that it will be assigned a network address, and thus may be used to place the first subordinate device 108 into a network address receiving mode wherein the network address of the first subordinate device 108 may be set by the supervisor 102.

Once the first subordinate device 108 has been assigned a network address, the first subordinate device 108 may couple the first address line to the second address line so that the signal propagates to the second subordinate device 110. As before, when the second subordinate device 110 receives the signal, it may enter a network address receiving mode so that the supervisor 102 can assign a network address to the second subordinate device 110. This process may continue for each respective subordinate device in the chain, so that when a subordinate device receives the signal it enters a network address receiving mode, and once it has been assigned a network address, the subordinate device propagates the signal to the next subordinate device in the chain. Thus, each subordinate device in the chain may be assigned a network address.

In some examples, the address lines are not used to transmit the actual network addresses, and are instead used only to indicate that the subordinate device should enter network address receiving mode. In such examples, network addresses are assigned using the communication bus 104 via one or more transmissions between the supervisor 102 and the relevant subordinate device.

However, as mentioned above, assigning network addresses is not instantaneous. In addition to the time for the signal to propagate along the address line portions, it can also take time for subordinate devices to enter and exit network address receiving mode, it can take time to transmit network addresses on the communication bus, it can take time to verify that the intended device has received the intended network address, and so forth. During this time, network connections and/or network resources may not be available to devices on the network, including subordinate devices. For example, if the second subordinate device 110 is being assigned its network address, the communication bus 104 may be unavailable for use by the first subordinate device 108 or any other subordinate devices on the network (because the communication bus 104 is being used by the supervisor 102 and second subordinate device 110 for assigning the network address to the second subordinate device 110).

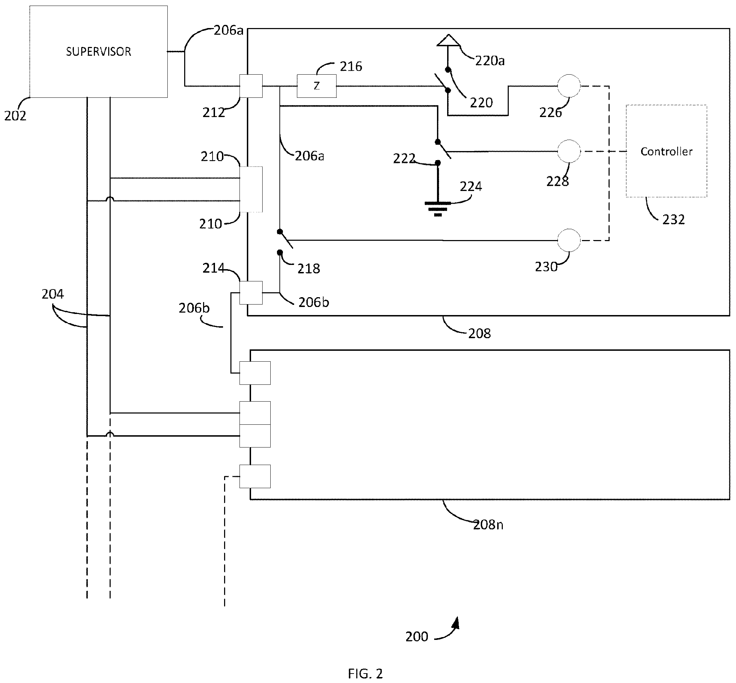

To access the network connections and/or network resources of the network, subordinate devices may contain internal mechanisms (one example of which shall be discussed below, with respect to FIG. 2) that permit the subordinate devices to alter the signal on the address line. In some examples, the subordinate devices alter the signal on the address line by pulling a voltage on the address line up or down to a target voltage (also referred as reference voltage, reference voltage level or predetermined voltage) or target range of voltages (also referred as predetermined range of voltages or predetermined voltage range). However, there are many methods by which the subordinate devices can alter the signal, including, but not limited to, injecting current into the address line, providing pulses of current or voltage to the address line, grounding the address line, generating noise on the address line, drawing power from the address line, and so forth.

When a subordinate device alters the signal in the predetermined manner (e.g., pulling it to a target voltage or target voltage range), the supervisor 102 may detect the alteration of the signal and may pause or terminate the network addressing process.

In some examples, when the network addressing process is terminated or paused, the supervisor 102 uses the communication bus 104 to determine which subordinate device altered the signal and why. The supervisor 102 and/or relevant subordinate device may then take actions that correspond to and/or address why the subordinate device altered the signal. For example, if a subordinate device is a battery pack experiencing a fault, the supervisor 102 may determine this via communication with the subordinate device, and then may disconnect or deactivate the battery pack, or inform a user or other entity of the issue, may control the devices receiving power from the battery pack to take protective action, and so forth.

FIG. 2 illustrates a networked system 200 according to an example. The networked system 200 may be the same as the networked system 100 in FIG. 1 in some examples.

The networked system 200 includes a supervisory device 202 ("supervisor 202"), a communication bus 204 with positive and negative lines, a first address line 206a, a second address line 206b, and one or more subordinate devices, illustrated as a first subordinate device 208 and a next subordinate device 208n. The first subordinate device 208 and next subordinate device 208n may be identical or functionally equivalent with respect to the features described herein (though the subordinate devices may otherwise differ). As a result, discussion of the first subordinate device 208 applies equally to the next subordinate device 208n. For example, the term "next subordinate device" may be substituted in place of "first subordinate device" in the discussion below.

The first subordinate device 208 has a bus input 210, an address line input 212 ("input 212"), an address line output 214 ("output 214"), an impedance 216 (also referred to as first impedance), a first switch 218, a second switch 220, a third switch 222, a reference node 224, a first node 226, a second node 228, and a third node 230. The first subordinate devices 208 may also include an controller 232.

The first subordinate device may comprise a first enable switch having an open and closed state, the first enable switch being coupled to an ID input, wherein the first enable switch is configured to be in a closed state responsive to an input signal being present on the ID input, and to be in an open state responsive to the input signal being absent from the ID input. The first enable switch may correspond to the second switch.

The first subordinate device may comprise a fault switch configured to receive a respective fault signal, wherein responsive to receiving the respective fault signal, the fault switch is set into a closed state. The fault switch may correspond to the third switch.

The supervisor 202 is coupled to the communication bus 204 and to the first address line 206a. The communication bus 204 is coupled to each of the subordinate devices 208, 208n via the respective bus input 210 of the first subordinate device 208. The first address line 206a is coupled to a respective input 212 of a first subordinate device 208 of the subordinate devices 208. The second address line 206b is coupled to a respective output 214 of the first subordinate device and an input of the second subordinate device (e.g., the next subordinate device in the chain).

Within the first subordinate device 208, the first address line 206a continues to be coupled to the first switch 218, the second switch 220, and the impedance 216. This portion of the first address line 206a may be different from the portion of the first address line 206a outside the first subordinate device 208. The first switch 218 is coupled between the internal portion of the second address line 206b and the internal portion of the first address line 206a. The first switch 218 is also coupled to the third node 230. The impedance 216 is further coupled to the second switch 220, and the second switch 220 is coupled to the first node 226. The third switch 222 is coupled between the first address line 206a and the reference node 224, and is also coupled to the second node 228. The controller 232 may be coupled to each of the first node 226, second node 228, third node 230, and/or the reference node 224.

The supervisor 202 may, when assigning addresses to subordinate devices, assert a signal on the first address line 206a. The signal on the first address line 206a may be a voltage, or any other type of electrical signal.

Within the first subordinate device 208, the three switches 218, 220, 222 may be normally open. When a voltage is present on the first address line 206a from the supervisor 202, and each of the switches is open, the voltage may cause the second switch 220 to close. When the second switch 220 is closed, the first node 226 may be coupled to a voltage (or other signal) that indicates to the first subordinate device 208 that the first subordinate device 208 should enter addressing mode and prepare to receive a network address, via the communication bus 204, from the supervisor 202. For example, a node 220a may be coupled to the second switch 220, and the node may be coupled to, or be the same as, the reference node 224.

Once the first subordinate device 208 has been assigned a network address, the third node 230 may assert a voltage (or other signal) to cause the first switch 218 to close. Simultaneously, in some examples, the second switch 220 may open or be controlled to open (e.g., the presence of a signal at the third node 230 may cause the second switch 220 to open). When the first switch 218 is closed, the first address line 206a and second address line 206b are connected. Thus, the next subordinate device 208n may receive an address signal on the second address line 206b. Since the next subordinate device 208n is and/or may be identical to the first subordinate device 208, the signal on the second address line 206b may cause the next subordinate device 208n to enter addressing mode.

The third switch 222 is controlled by the second node 228. When a signal is present on the second node 228, such as a voltage, the third switch 222 may close, thereby linking the reference node 224 and the first address line 206a. A signal may be asserted on the second node 228 when the first subordinate device wishes to use network resources or connections, for example when experiencing a fault. When the third switch 222 is closed, the first address line 206a is pulled up or down to the voltage of the reference node 224 (which may be a reference voltage or a voltage of 0V). Furthermore, if the first switch 218 is also closed, then the voltage of one or more following address lines in the chain may also be pulled up or down to the voltage of the reference node 224. The supervisor 202 may detect that the voltage on the address lines has changed to the voltage of the reference node 224, and may therefore terminate and/or pause the addressing process to identify which subordinate devices caused the voltage to change to that of the reference node 224.

When multiple subordinate devices are chained together, those devices that have their respective first switch 218 closed effectively share a common address line with every subordinate device between the supervisor and whichever subordinate device is the first in the chain to have its respective first switch 218 open. Because of this, when any subordinate device that shares the common address line can pull the voltage on the address line (and therefore on the first address lion 206a) up or down to the reference voltage.

The controller 232 may provide the signals at the second and third nodes 228, 230, and may receive the signal at the first node 226. The controller 232 may be, for example, a controller of the first subordinate device 208, and thus may handle signal processing and management and generally control the first subordinate device 208. Accordingly, the controller 232 may cause the second switch 220 to close after a network address has been assigned, may process the instructions from the supervisor 202 (e.g., may process instructions to set a network address), may determine when it is appropriate to close the first or third switches 218, 222, and so forth.

In some examples, the second node 228 may be an alarm input (or alarm node) used to pull up and/or down the voltage on the address line (or address lines) so as to provide an indication (e.g., an alarm) to the supervisor 202 that a fault has occurred. That is, the presence of a signal at the second node 228 may be one type of alarm signal used to indicate that the first subordinate device 208 wants to use network resources. Following the change in voltage (or change in the signal) on the address line, the supervisor 202 may then raise an alarm of its own, which may be auditory, readable, visual, or any other form. Common types of alarms include audible alarm sounds (such as klaxons), visual alarms (such as flashing and/or strobing lights of various colors), sending emails, text messages, or other forms of written communication to an individual (such as an engineer or safety manager) or system (such as an internal audit system or maintenance management program), and so forth.

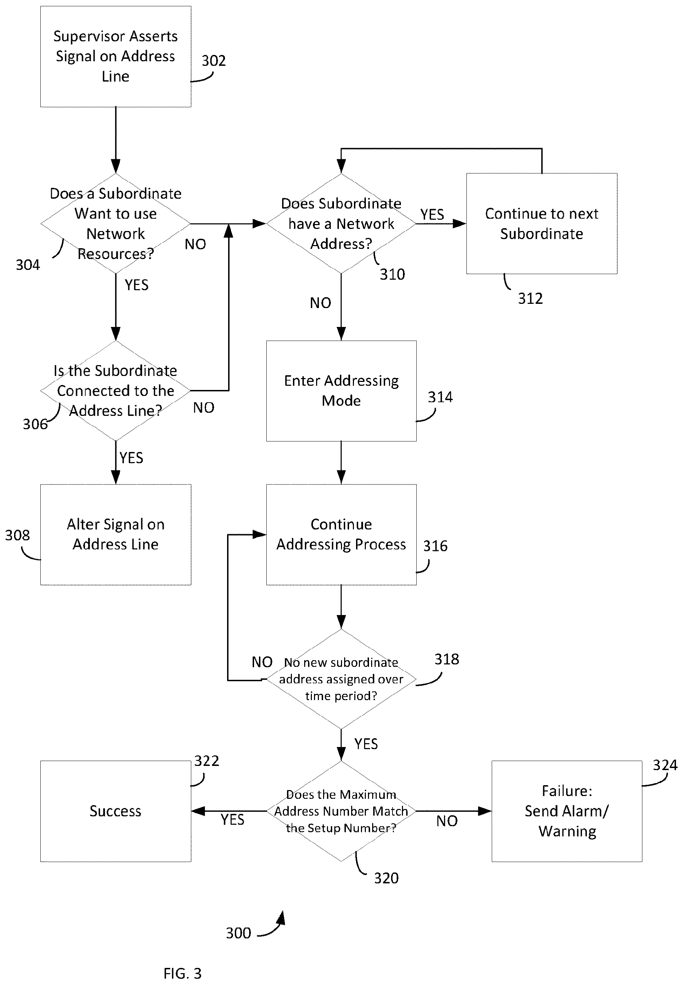

FIG. 3 illustrates a process 300 for pausing or terminating an addressing process according to an example.

At act 302, a supervisory device ("supervisor"), such as the supervisors 102, 202 of FIGS. 1 and 2, asserts a signal on an address line (such as the address lines of FIGS. 1 and 2). The signal may be an electromagnetic signal, such as a voltage or current, and may be time-varying (e.g., a waveform) or constant. In some examples, the signal may be a voltage. Once the signal is asserted, the process 300 may continue to act 304.

At act 304, a subordinate (such as the subordinate devices of FIGS. 1 and 2) may want to use network resources (such as network connections). The subordinate may want to use the network resources for varying different reasons, for example, due to detecting a fault, though there may be other reasons. If a subordinate wants to use network resources (304 YES), the process 300 may continue to act 306. If a subordinate does not want to use network resources (304 NO), the process 300 may continue to act 310.

At act 306, the subordinate may or may not be connected to the address line. For example, as discussed above, the various subordinates may effectively share a common address line when certain switches or connections are available (e.g., when the first switch 218 of FIG. 2 is in a closed state). If the subordinate device is not connected to the common address line, the subordinate device cannot alter the signal on the address line, and thus waits until it shares the common address line. Accordingly, if the subordinate device is not connected to the address line (306 NO), the process 300 may continue to act 310. If the subordinate device is connected to the address line (306 YES), the process 300 may continue to act 308.

At act 308, the subordinate device is connected to the address line, and may alter the signal on the address line. The subordinate device may alter the signal on the address line in a number of ways. For example, the subordinate device may pull the voltage on the address line up or down to a desired value or range of values (e.g., as with closing the third switch 222 of FIG. 2). However, the subordinate device may alter the signal in other ways, for example, by providing pulses of voltage or current on the address line, generating noise on the address line above a noise threshold, and so forth. When the altered signal is detected by the supervisor, the supervisor may pause or terminate the addressing process to take any desired actions. For example, the supervisor may determine which device altered the signal on the address line and then communicate with that device to determine the reason the device altered the signal, and then take an appropriate response.

Returning now to act 304, as mentioned above, sometimes no subordinate may want to use the network resources (304 NO). Similarly, with respect to act 308, sometimes a subordinate that wants to use network resources may be unable to do so because the supervisor is monopolizing the system during the addressing process (306 NO). In those cases, the process 300 may proceed to act 310.

At act 310, the supervisor and/or subordinate determine whether a given subordinate has a network address already assigned to it. In some cases, this may be virtually automatic, wherein a device that has a network address may disable addressing mode until receiving instructions via the communication bus (rather than merely detecting a signal on the address line). In other cases, some internal decision making may occur, wherein the subordinate and/or supervisor may communicate to determine if a given subordinate has a network address. If a subordinate has a network address (310 YES), the process 300 may continue to act 312, where the same inquiry is made of the next and/or last subordinate device in the chain. Otherwise, if the subordinate device does not have a network address (310 NO), the process 300 may continue to act 314.

At act 314, the subordinate receives a signal on the address line and enters addressing mode. In some examples, the subordinate enters addressing mode only in response to the first time the subordinate receives the signal on the address line, and, in future, will not enter addressing mode upon receiving or detecting a signal on the address line (unless the subordinate is reset or otherwise instructed to enter addressing mode upon receiving the signal on the address line). The process 300 may then continue to act 316.

At act 316, the subordinate is assigned a network address and the process 300 may continue (for example, by returning to an earlier act such as act 304, act 310, and so forth).

In some examples, acts 314 and 316 may be omitted if the subordinate receiving the address signal wants to use network resources, in which case the process could instead proceed to act 308. This example illustrates that the precise order of the acts in process 300 may be different than as described, and that process 300 is but one example of processes for pausing and/or terminating an addressing process. The process 300 may then continue to act 318.

At act 318, the supervisor determines whether a new device has been assigned an address within a period of time, such as a timeout period. The supervisor may determine that no new addresses have been assigned within the timeout period by, for example, monitoring the amount of time that passes after assigning the previous network address. If the supervisor determines that no new devices have been added in the timeout period (318 YES), the process 300 may then continue to act 320. If the supervisor determines that a new address has been assigned within the timeout period (318 NO), then the process 300 may return to act 316.

At act 320, the supervisor determines whether the number of addresses assigned matches a predetermined number of devices to be set up. For example, a user or other entity may have indicated to the supervisor that X number of devices are to be set up, but X+Y or X-Y number of devices may have been set up instead (X and Y being, for example, integers). For example, if 10 devices are intended to be set up, but only 8 devices are set up, or 12 devices are set up, then the supervisor may determine that the number of devices actually assigned network addresses does not match the predetermined number of devices to be set up. If the number of devices actually assigned network addresses does not match the predetermined number of devices to set up (320 NO), the process 300 may continue to act 324. If the number of devices actually assigned network addresses does match the predetermined number of devices to set up (320 YES), the process 300 may continue to act 322.

At act 322, the supervisor may determine that the correct number of devices were assigned network addresses, and proceed to function normally. For example, the supervisor may control the subordinates to operate in their respective normal manners and/or modes of operation, and the system overall may operate in the desired manner.

At act 324, the supervisor may determine that the correct number of devices were not assigned network addresses. For example, fewer or more subordinates than the predetermined number to be set up may have actually been set up. Then the supervisor may terminate or pause operation of the system as a whole, disconnect devices, raise an alarm (indicating, for example, that an incorrect number of devices were set up), and so forth.

In this way, acts 318-324 permit the supervisor to ensure that the correct number of devices intended to be assigned network addresses (e.g., the correct number of devices to be set up) were actually assigned network addresses, and if an incorrect number was assigned, the supervisor can take remedial action. This may be advantageous because if more subordinate devices or fewer subordinate devices than intended are operating on the network, the discrepancy between the actual number and intended number of subordinate devices may indicate that something was set up incorrectly, that the system is improperly coupled, that network addresses were assigned multiple times to a single device, and so forth.

Examples of the methods and systems discussed herein are not limited in application to the details of construction and the arrangement of components set forth in the description or illustrated in the accompanying drawings. The methods and systems are capable of implementation in other embodiments and of being practiced or of being carried out in various ways. Examples of specific implementations are provided herein for illustrative purposes only and are not intended to be limiting. In particular, acts, components, elements and features discussed in connection with any one or more examples are not intended to be excluded from a similar role in any other examples.

Also, the phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are not intended to limit the presently disclosed systems or methods, their components, acts, or elements. The use herein of "including," "comprising," "having," "containing," "involving," and variations thereof is meant to encompass the items listed thereafter and equivalents thereof as well as additional items.

References to "or" may be construed as inclusive so that any terms described using "or" may indicate any of a single, more than one, and all of the described terms. In addition, in the event of inconsistent usages of terms between this document and documents incorporated herein by reference, the term usage in the incorporated features is supplementary to that of this document; for irreconcilable differences, the term usage in this document controls.

Various controllers, such as the controller 102, 232, may execute various operations discussed above. Using data stored in associated memory and/or storage, the controller 102, 232 also executes one or more instructions stored on one or more non-transitory computer-readable media, which the controller 102, 232 may include and/or be coupled to, that may result in manipulated data. In some examples, the controller 102, 232 may include one or more processors or other types of controllers. In one example, the controller 102, 232 is or includes at least one processor. In another example, the controller 102, 232 performs at least a portion of the operations discussed above using an application-specific integrated circuit tailored to perform particular operations in addition to, or in lieu of, a general-purpose processor. As illustrated by these examples, examples in accordance with the present disclosure may perform the operations described herein using many specific combinations of hardware and software and the disclosure is not limited to any particular combination of hardware and software components. Examples of the disclosure may include a computer-program product configured to execute methods, processes, and/or operations discussed above. The computer-program product may be, or include, one or more controllers and/or processors configured to execute instructions to perform methods, processes, and/or operations discussed above.

Having thus described several aspects of at least one embodiment, it is to be appreciated various alterations, modifications, and improvements will readily occur to those skilled in the art. Such alterations, modifications, and improvements are intended to be part of, and within the spirit and scope of, this disclosure. Accordingly, the foregoing description and drawings are by way of example only.

Below are provided a number of examples.

According to an example, it is provided a system comprising:
a first subordinate device coupled to a communication bus, a first address line, and a second address line, the first subordinate device including
- a first switch coupled between the first address line and the second address line and configured to selectively connect the first address line to the second address line,
- a first alarm input configured to receive an alarm signal, and
- a second switch configured to establish an alarm voltage on the first address line.

According to an example, the second switch is coupled between the first address line and a voltage node and configured to be in a closed state responsive to the alarm signal being present at the first alarm input, and to be in an open state responsive to the alarm signal being absent from the first alarm input.

According to an example, the system further comprises a second subordinate device coupled to the communication bus and to the second address line, the second subordinate device including a third switch coupled between the second address line and the voltage node, and a second alarm input configured to receive a second alarm signal, wherein the third switch is configured to be in a closed state responsive to the second alarm signal being present at the second alarm input, and to be in an open state responsive to the second alarm signal absent from the second alarm input.

According to an example, the system further comprises a third subordinate device coupled to the communication bus and a third address line, the second subordinate device being coupled to the third address line and including a fourth switch coupled between the second address line and the third address line and configured to selectively connect the second address line and the third address line.

According to an example, the voltage node is configured to pull down a voltage on the first address line to a reference voltage level responsive to the first switch and the third switch both being in respective closed states.

According to an example, the first subordinate device includes a first impedance coupled between the first address line and a first enable switch, and the second subordinate device has a second impedance coupled between the second address line and a second enable switch.

According to an example, the system further comprises:
- one or more additional subordinate devices, a leading subordinate device of the one or more additional subordinate devices being coupled to the second address line, and each other subordinate device of the one or more additional subordinate devices being coupled to at least one preceding subordinate device of the one or more additional subordinate devices via a respective preceding address line, and being further coupled to at least one following subordinate device of the one or more additional subordinate devices via a respective following address line; and
- a supervisory device configured to detect whether a voltage of the first address line falls within a predetermined range of voltages, and responsive to determining that the voltage falls within the predetermined range of voltages, to determine, via the communication bus, when subordinate devices of the first subordinate device and the one or more additional subordinate devices have respective alarm signals present on respective alarm inputs.

According to an example, the first subordinate device further includes a first enable switch having an open and closed state, the first enable switch being coupled to an ID input, wherein the first enable switch is configured to be in a closed state responsive to an input signal being present on the ID input, and to be in an open state responsive to the input signal being absent from the ID input.

According to an example, responsive to the first enable switch being in the closed state, the first subordinate device is configured to receive a network address from the communication bus and to set the network address as the network address of the first subordinate device.

According to an example, the voltage node has a reference voltage level and is configured to pull a voltage on at least the first address line down to the reference voltage level responsive to the second switch being in a closed state.

According to an example, it is provided a method of detecting a fault in a battery pack, the method comprising:
- providing a first voltage on a first address line, the first address line coupled to a first subordinate device;
- detecting a fault;
- responsive to detecting the fault, providing a second voltage on the first address line;
- detecting the second voltage on the second address line;
- responsive to detecting the second voltage on the second address line, providing instructions via a communication bus to a subordinate device experiencing the fault.

According to an example, the method further comprises coupling the first address line in series with one or more additional address lines, the first address line and each additional address line of the one or more address lines being coupled to a respective fault switch of a respective subordinate device, each respective fault switch being configured to receive a respective fault signal, wherein responsive to receiving the respective fault signal the respective fault switch is set into a closed state.

According to an example, in the closed state, the respective fault switch couples a respective address line of the first address line and the one or more additional address lines to a voltage node, the voltage node having a predetermined voltage.

According to an example, connecting the respective address line to the voltage node pulls the voltage of the first address line to the predetermined voltage of the voltage node.

According to an example, responsive to detecting the predetermined voltage on the first address line, determining that a fault has occurred in at least one subordinate device.

According to an example, the method further comprises, responsive to detecting the predetermined voltage on the first voltage bus, monitoring signals on the communication bus to determine an identity of the at least one subordinate device experiencing the fault.

According to an example, it is proposed a non-transitory computer-readable medium containing thereon instructions for detecting faults in one or more subordinate devices, the instructions, when executed by at least one processor, causing:
- a supervisory device to provide a first voltage to a first address line, the first address line being coupled between the supervisory device and a subordinate device of the one or more subordinate devices;
- the supervisory device to detect changes in the first voltage;
- the supervisory device to determine whether the first voltage falls within a predetermined voltage range, the predetermined voltage range corresponding to a range of voltages that indicate a fault has occurred in at least one of the one or more subordinate devices; and
- the supervisory device to monitor communications on a communication bus to determine which subordinate device of the one or more subordinate devices is experiencing the fault.

According to an example, the instructions, when executed by the at least one processor, further cause:
responsive to providing the first voltage on the first address line, the supervisory device to provide a network address to the subordinate device.

According to an example, the instructions, when executed by the at least one processor, further cause:
responsive to providing the first address, a switching device to be in a closed state to couple the first address line to a second address line.

According to an example, the instructions, when executed by the at least one processor, further cause:
the subordinate device to detect a fault condition; and
responsive to detecting the fault condition, the subordinate device to control a switching device to be in a closed state, the switching device being coupled to ground and configured, when closed, to pull the first voltage of the first address line to a target voltage that falls within the predetermined voltage range.

## Claims

1. A system (100, 200) comprising:
a first subordinate device (108, 208) coupled to a communication bus (104, 204), a first address line (206a), and a second address line (206b), the first subordinate device (108, 208) including:
- a first switch (218) coupled between the first address line (206a) and the second address line (206b) and configured to selectively connect the first address line to the second address line,
- a first alarm input configured to receive an alarm signal, and
- a second switch (220) configured to establish an alarm voltage on the first address line.

2. The system (100) of claim 1 wherein the second switch (220) is coupled between the first address line (206a) and a voltage node and configured to be in a closed state responsive to the alarm signal being present at the first alarm input, and to be in an open state responsive to the alarm signal being absent from the first alarm input.

3. The system (100) of claim 2 further comprising:
a second subordinate device (110) coupled to the communication bus (104) and to the second address line, the second subordinate device (110) including a third switch (222) coupled between the second address line and the voltage node, and a second alarm input configured to receive a second alarm signal, wherein the third switch (222) is configured to be in a closed state responsive to the second alarm signal being present at the second alarm input, and to be in an open state responsive to the second alarm signal absent from the second alarm input.

4. The system (100) of claim 3 wherein the voltage node is configured to pull down a voltage on the first address line to a reference voltage level responsive to the first switch (218) and the third switch (222) both being in respective closed states.

5. The system (100) of any of the claims 3 or 4 wherein the first subordinate device (108, 208) includes a first impedance (216) coupled between the first address line and a first enable switch, and the second subordinate device (110) has a second impedance coupled between the second address line and a second enable switch.

6. The system (100) of claim 1 further comprising:
one or more additional subordinate devices (208n), a leading subordinate device of the one or more additional subordinate devices being coupled to the second address line, and each other subordinate device of the one or more additional subordinate devices (208n) being coupled to at least one preceding subordinate device of the one or more additional subordinate devices via a respective preceding address line, and being further coupled to at least one following subordinate device of the one or more additional subordinate devices via a respective following address line; and
a supervisory device (102, 202) configured to detect whether a voltage of the first address line falls within a predetermined range of voltages, and responsive to determining that the voltage falls within the predetermined range of voltages, to determine, via the communication bus, when subordinate devices of the first subordinate device (108, 208) and the one or more additional subordinate devices (208n) have respective alarm signals present on respective alarm inputs.

7. The system (100) of claim 1 wherein the first subordinate device (108, 208) further includes a first enable switch having an open and closed state, the first enable switch being coupled to an ID input, wherein the first enable switch is configured to be in a closed state responsive to an input signal being present on the ID input, and to be in an open state responsive to the input signal being absent from the ID input.

8. The system of claim 7 wherein, responsive to the first enable switch being in the closed state, the first subordinate device (108, 208) is configured to receive a network address from the communication bus (104, 204) and to set the network address as the network address of the first subordinate device (108, 208).

9. The system of any of the claims 1 to 8 taken in combination with claim 2 wherein the voltage node has a reference voltage level and is configured to pull a voltage on at least the first address line down to the reference voltage level responsive to the second switch (220) being in a closed state.

10. A method of detecting a fault in a battery pack, the method comprising:
- providing a first voltage on a first address line, the first address line coupled to a first subordinate device (108, 208);
- detecting a fault;
- responsive to detecting the fault, providing a second voltage on the first address line;
- detecting the second voltage on the second address line;
- responsive to detecting the second voltage on the second address line, providing instructions via a communication bus to a subordinate device experiencing the fault.

11. The method of claim 10 further comprising:
coupling the first address line in series with one or more additional address lines, the first address line and each additional address line of the one or more address lines being coupled to a respective fault switch of a respective subordinate device, each respective fault switch being configured to receive a respective fault signal, wherein responsive to receiving the respective fault signal the respective fault switch is set into a closed state.

12. The method of claim 11 wherein, in the closed state, the respective fault switch couples a respective address line of the first address line and the one or more additional address lines to a voltage node, the voltage node having a predetermined voltage.

13. The method of claim 12 wherein, responsive to detecting the predetermined voltage on the first address line, determining that a fault has occurred in at least one subordinate device.

14. The method of claim 13 further comprising, responsive to detecting the predetermined voltage on the first address line, monitoring signals on the communication bus to determine an identity of the at least one subordinate device experiencing the fault.

15. A non-transitory computer-readable medium containing thereon instructions for detecting faults in one or more subordinate devices, the instructions, when executed by at least one processor, causing the at least one processor to implement the method according to any of the claims 10 to 14.
